# EUROPEAN PATENT APPLICATION

(11) **EP 4 093 161 A1**
(43) Date of publication of application: **23.11.2022**
(21) Application number: 22174198.6
(22) Date of filing: 18.05.2022
(51) Int. Cl.: H05K 1/14, H05K 3/36

(54) **CIRCUIT BOARD ASSEMBLY**

(30) Priority: 19.05.2021 JP 2021084915
(71) Applicant: Tyco Electronics Japan G.K., Takatsu-ku Kawasaki Kanagawa 213-8535 (JP)
(72) Inventor: Dobashi, Daisuke, Kawasaki-shi, 213-8535 (JP); Kimura, Takeshi, Kawasaki-shi, 213-8535 (JP)
(74) Representative: Johnstone, Douglas Ian

(57) **Abstract**

A circuit board assembly (100) in which an angle between circuit boards (10, 20) and a positional relationship between the circuit boards (10, 20) can be precisely adjusted and low cost is attained. The circuit board assembly (100) includes a first circuit board (10), a second circuit board (20), and a metal fitting (50). The metal fitting (50) is a flat metal plate punched in a strip shape and bent to permit respective end portions (51, 52) thereof to be inserted into respective through holes (13, 23) of the circuit boards (10, 20). An example of the metal fitting (50) to be adopted is a metal fitting (50) made of a material and having dimensions and the like so as to be rigid enough to maintain a predetermined tolerance for an angle between the first circuit board (10) and the second circuit board (20) even if a posture in a direction of gravity of the circuit board assembly (100) is changed even if the metal fitting (50) has been bent once.

## Description

### Technical Field

The present invention relates to a circuit board assembly in which a plurality of circuit boards are connected to one another.

### Background Art

A structure having a bent shape including a plurality of circuit boards connected to one another is known.

For example, JP2004-311813A discloses two circuit boards connected to each other by a jumper wire.

In JP2004-311813A, the length of the jumper wire is selected to be ample for the purpose of reducing a load applied to respective connections between the jumper wire and the two circuit boards due to bending between the circuit boards.

Each of JP2019-134081A and JP2020-025012A discloses two circuit boards disposed to each other at 90° by forming a protrusion on an end surface of one of the two circuit boards, forming an insertion hole into which the protrusion is to be inserted on the other circuit board, and inserting the protrusion into the insertion hole.

### Summary of Invention

### Technical Problem

There are situations in which a circuit board assembly, in which an angle between circuit boards and a relative positional relationship between the circuit boards need to be accurately controlled is required. For example, where a circuit board assembly, including a plurality of circuit boards connected to one another, is further assembled to a third circuit board.

In the circuit board assembly including circuit boards connected to each other by the jumper wire, as disclosed in the above-described JP2004-311813A, if there is no support, other than the jumper wire, an angle between the circuit boards and a positional relationship between the circuit boards can not be controlled. The circuit board assembly is unsuitable for a circuit board assembly requiring a strict angle and positional relationship.

In the circuit board assembly having a structure in which one of the circuit boards and the other circuit board are respectively provided with the protrusion and the insertion hole and the protrusion is inserted into the insertion hole, as disclosed in each of the above-described JP2019-134081A and JP2020-025012A, the circuit boards are combined with each other and are fixed to each other by soldering, for example, and then an angle between the circuit boards and a positional relationship between the circuit boards is not easily changed. However, to implement the circuit board assembly having this structure, the circuit boards need to be cut out from a circuit board of a large size, and then the circuit boards need to be combined with each other. Accordingly, in a combination stage, the circuit boards need to be fixed to each other after the angle between the circuit boards and the positional relationship between the circuit boards have been strictly adjusted. The adjustment takes time and cost.

The present invention has been made in view of the above-described circumstances, and is directed to providing a circuit board assembly in which an angle between circuit boards and a positional relationship between the circuit boards are strictly adjusted and low cost is achieved.

### Solution to Problems

A first circuit board assembly according to the invention that achieves the above-described object includes a first circuit board, a second circuit board having a first side extending adjacent to and parallel to a first side of the first circuit board and being in a position having an angle excluding 180° to the first circuit board, and a metal fitting including a portion bent at an angle corresponding to the angle, spanning both the respective first sides of the first circuit board and the second circuit board, and fixed to both the first circuit board and the second circuit board, in which the metal fitting has a rigidity which results in a bent posture being maintained regardless of respective postures of the first circuit board and the second circuit board with respect to gravity. Alternatively a circuit board assembly according to the invention comprises: a first circuit board having a major flat plane and first side (or edge) and; a second circuit board having major flat plane disposed at an angle other than 180° with respect to the major flat plane of the first circuit board and a first side (or edge) which is adjacent to and parallel to the first side of the first circuit board; and a metal fitting fixed to both the first circuit board and the second circuit board, spanning between the first sides of the first and second circuit boards and having a bent configuration, wherein the metal fitting has a rigidity which is sufficient to maintain a juxtaposition of the first circuit board relative to the second circuit board. In a situation in which the circuit board assembly is supported by only one of the circuit boards, preferable the juxtaposition is maintained regardless of an orientation in which the circuit board assembly is supported.

With the first circuit board assembly according to the invention, a circuit board assembly that has been more strictly adjusted at low cost can be implemented than the circuit board assemblies respectively disclosed in the above-described JP2004-311813A, JP2019-134081A and JP2020-025012A.

A second circuit board assembly according to the invention that achieves the above-described object includes a first circuit board, and a second circuit board having a first side extending adjacent to and parallel to a first side of the first circuit board and being in a position having an angle excluding 180° to the first circuit board, and a bent plate-shaped metal fitting including a portion bent at an angle corresponding to the angle, spanning the respective first sides of both the first circuit board and the second circuit board, and fixed to both the first circuit board and the second circuit board.

With the second circuit board assembly according to the invention, a circuit board assembly that can be bent with a corresponding force and has been precisely adjusted at low cost, adjustment of which is completed upon adjustment of only a bending angle by adopting a metal fitting rigid enough to maintain a bent shape.

In each of both the first circuit board assembly and the second circuit board assembly according to the invention, both the first circuit board and the second circuit board respectively include protrusions having second sides to be mounted on a support portion, protruding from the second sides, and to be inserted into insertion portions formed in the support portion, and the metal fitting is rigid enough to maintain an angle at which the protrusions can be respectively inserted into the insertion portions between the first circuit board and the second circuit board before being inserted into the support portion.

The metal fitting, preferably comprises a metal fitting rigid enough to maintain an angle at which it can be inserted into an insertion portion having an accuracy at a level described below.

In this case, the first circuit board, the second circuit board, and the support portion preferably form one circuit.

In each of both the first circuit board assembly and the second circuit board assembly according to the invention, the first circuit board and the second circuit board preferably respectively include a first circuit portion and a second circuit portion that are electrically connected to each other to perform a function, and the metal fitting preferably provides mechanical fixing of the first circuit board and the second circuit board and electrical connection between the first circuit portion and the second circuit portion.

In this case, both the first circuit portion and the second circuit portion may be respectively circuit portions constituting an antenna.

The metal fitting is designed taking into consideration mechanical rigidity and an electrical characteristic to make a metal fitting which can perform both mechanical metal fixing and electrical connection. This implements a circuit board assembly having a simpler structure than that of a combination of a metal fitting for mechanical fixing and an electrical wiring separate from the metal fitting. When the circuit board assembly is used as an antenna, for example, an antenna having a stabler performance than that of a combination of the metal fitting and the electrical wiring is implemented.

In either one of the first circuit board assembly and the second circuit board assembly according to the invention, the first circuit board and the second circuit board preferably respectively include receiving portions that receive the metal fitting, and the metal fitting is preferably press-fitted into each of the receiving portions.

When press-fitting is adopted, no subsequent connection process is required, and a lower-cost circuit board assembly is implemented.

Alternatively, in either one of the first circuit board assembly and the second circuit board assembly according to the invention, the above-described metal fitting is preferably soldered to both the first circuit board and the second circuit board.

The soldering requires no special process because it is performed simultaneously with soldering of another circuit component on the circuit board, and provides a reliable connection and a reduction in cost.

### Advantageous Effects of Invention

As described above, according to the invention, an angle between circuit boards and a positional relationship between the circuit boards can be precisely adjusted, and a circuit board assembly that can be provided at a low cost is provided.

### Brief Description of Drawings

Figure 1 is a process view illustrating an example of a manufacturing method applicable to the manufacture of a circuit board assembly according to the invention.
Figure 2 is a diagram illustrating the accuracy of a general through hole on a circuit board.
Figure 3 is a diagram illustrating a required accuracy of a relative position between terminals to be smoothly inserted into respective through holes.
Figure 4 is a diagram illustrating a circuit board assembly according to a first embodiment of the invention.
Figure 5 is a diagram illustrating a circuit board assembly according to a second embodiment of the invention.
Figure 6 is a diagram illustrating a circuit board assembly according to a third embodiment of the invention.
Figure 7 is a diagram illustrating a circuit board assembly according to a fourth embodiment of the invention.
Figure 8 is a diagram illustrating a circuit board assembly according to a fifth embodiment of the invention.
Figure 9 is a diagram illustrating a circuit board assembly according to a sixth embodiment of the invention.
Figure 10 is a diagram illustrating a circuit board assembly according to a seventh embodiment of the invention.
Figure 11 is a diagram illustrating a circuit board assembly according to an eighth embodiment of the invention.
Figure 12 is a diagram illustrating a circuit board assembly according to a ninth embodiment of the invention.
Figure 13 is a diagram illustrating a circuit board assembly according to a tenth embodiment of the invention.
Figure 14 is a diagram illustrating a circuit board assembly according to an eleventh embodiment of the invention.
Figure 15 is a diagram illustrating a circuit board assembly according to a twelfth embodiment of the invention.

### Description of Embodiments

Embodiments of the invention will be described below.

First, an example of a preferable manufacturing method that can be adopted as a method for manufacturing a circuit board assembly according to the invention will be described. The circuit board assembly according to the invention may be manufactured using any method.

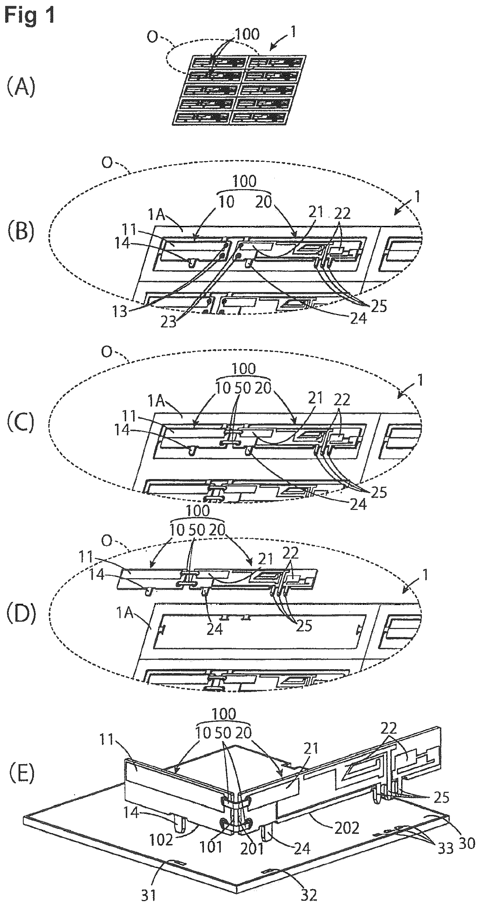

Figure 1 is a process view illustrating an example of a manufacturing method applicable to the manufacture of the circuit board assembly according to the invention.

Figure 1(A) illustrates a circuit board 1 of a large size.

Figure 1(B) is an enlarged view of a portion of an ellipse O indicated by a dotted line in Figure 1(A).

Eight circuit board assemblies 100 are manufactured from the circuit board 1 of a large size. In description herein, a portion to be a circuit board assembly after manufacture is assigned the same reference numeral as that after the manufacture and is referred to as a circuit board assembly 100 even in a stage before being completed as the circuit board assembly. The same applies to a portion to be a first circuit board 10 or a second circuit board 20 after the manufacture.

In Figures 1(A) and 1(B), a circuit pattern has already been printed, and punching has been further performed, to form respective prototypes of the first circuit board 10 and the second circuit board 20. The first circuit board 10 and the second circuit board 20 respectively include a first circuit portion 11 and a second circuit portion 21 that are electrically connected to each other and function as an antenna. A third circuit portion 22 is further formed in the second circuit board 20.

The first circuit board 10 and the second circuit board 20 in a stage illustrated in Figure 1(A) and Figure 1(B) enter a state partially connected to a frame 1A obtained by punching the first circuit board 10 and the second circuit board 20 from the circuit board 1 of a large size such that a position on the circuit board 1 of a large size is maintained. Through holes 13 and 23 into which a metal fitting 50 is to be inserted are respectively formed in both the first circuit board 10 and the second circuit board 20. The through holes 13 and 23 each correspond to an example of a receiving portion referred to elsewhere in the specification. The receiving portion is not necessarily a through hole.

Figure 1(C) is a diagram illustrating a state where the metal fitting 50 is inserted into the respective through holes 13 and 23 in the first circuit board 10 and the second circuit board 20 illustrated in Figures 1(A) and 1(B).

The metal fitting 50 is manufactured separately from the first circuit board 10 and the second circuit board 20 illustrated in Figures 1. Specifically, an example of the metal fitting 50 is a flat metal plate punched in a strip shape and bent to respectively insert both its end portions into the through holes 13 and 23 or a metal fitting including the flat metal plate. For the metal fitting 50, for example, an element other than the flat metal plate, such as a coating film such as an insulating coating film or a non-metallic structure for entirely increasing a strength may be further partially combined with the bent flat metal plate. In selecting the material for the metal fitting 50 the material's rigidity and electrical conductivity are taken into consideration to take account of mechanical coupling between the first circuit board 10 and the second circuit board 20 and also to take account of electrical connection therebetween. In an example illustrated in Figure 1, the metal fitting 50 has its end portions respectively inserted into the through holes 13 and 23, and is soldered thereto by pouring solder into respective gaps between the through holes 13 and 23 and the end portions.

At this stage, a relative position between the first circuit board 10 and the second circuit board 20 is fixed. At this stage, both the first circuit board 10 and the second circuit board 20 remain connected to the frame 1A of the circuit board 1 of a large size, and the first circuit board 10 and the second circuit board 20 are fixed to each other with a high-accuracy and in a relative positional relationship without performing special adjustment.

Figure 1(D) is a diagram illustrating a state where the circuit board assembly 100 is separated from the frame 1A of the circuit board 1 of a large size.

In the circuit board assembly 100 illustrated in Figure 1(D), the first circuit board 10 and the second circuit board 20 are coplanar. The circuit board assembly 100 is bent at a portion of the metal fitting 50 after being separated from the frame 1A, as illustrated in Figure 1(D). Here, the circuit board assembly 100 is bent at an angle of 90° as an example.

Figure 1(E) is an isometric view illustrating the circuit board assembly 100 and a third circuit board 30 after the bending. The third circuit board 30 corresponds to an example of a support portion referred to elsewhere in the specification.

A first side 201 of the second circuit board 20 extends adjacent to and parallel to a first side 101 of the first circuit board 10. The first circuit board 1 has a protrusion 14 protruding toward the third circuit board 30 from its second side 102. Similarly to this, the second circuit board 20 also has protrusions 24 and 25 protruding toward the third circuit board 30 from its second side 202.

Through holes 31, 32, and 33 are respectively formed at positions corresponding to the protrusions 14, 24, and 25. After the circuit board assembly 100 is bent, as illustrated in Figure 1(E), the protrusions 14, 24, and 25 are respectively inserted into and soldered to the through holes 31, 32, and 33. The protrusions 14, 24, and 25 and the through holes 31, 32, and 33 provide mechanical coupling and electrical connection between the first and second circuit boards 10 and 20 and the third circuit board 30. By the soldering, respective partial circuits formed in the first circuit board 10, the second circuit board 20, and the third circuit board 30 are connected to one another to form one circuit. Each of the protrusions 14, 24, and 25 corresponds to an example of a protrusion referred to in the specification, and each of the through holes 31, 32 and 33 corresponds to an example of an insertion portion referred to elsewhere in the specification.

The circuit board assembly 100 needs to be finished to a relative position and an opening angle between the first circuit board 10 and the second circuit board 20, which have been strictly adjusted to such an extent that the protrusions 14, 24, and 25 can be respectively smoothly inserted into the through holes 31, 32, and 33. The relative position between the first circuit board 10 and the second circuit board 20, before the first circuit board 10 and the second circuit board 20 are cut out from the circuit board 1 of a large size is highly accurately maintained. Thus, the circuit board assembly 100 may be bent such that only a bending angle of the metal fitting 50 ensures a defined accuracy.

Consider that a circuit board corresponding to the first circuit board 10 and a circuit board corresponding to the second circuit board 20 are separately cut out and the two circuit boards after the cutting are combined with each other, like in JP 2020-025012A cited above, for example. In this case, the two circuit boards need to be deliberately combined with and fixed to each other such that both a relative position and an opening angle therebetween each have a defined accuracy, which takes much time and cost.

On the other hand, a circuit board assembly according to each of the embodiments described below can adopt the manufacturing method illustrated in Figure 1 so that time and cost required for manufacture can be reduced.

For reference, the accuracy of a general through hole and a required assembly accuracy of two circuit boards are listed.

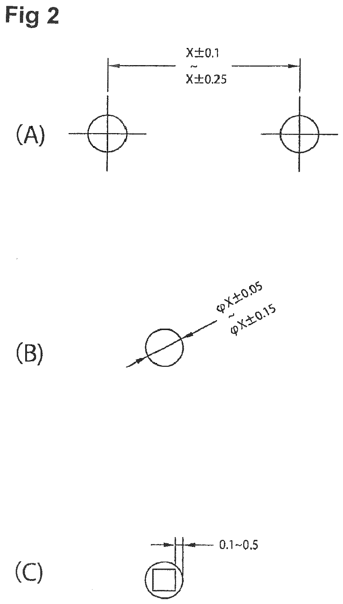

Figure 2 is a diagram illustrating the accuracy of a general through hole on a circuit board.

Figure 2(A) illustrates the accuracy of a positional relationship between respective general through holes on circuit boards. The accuracy has a tolerance of ± 0.1 mm to ± 0.25 mm for a true relative distance X between two through holes.

Figure 2(B) illustrates the accuracy of the diameter of a general through hole on a circuit board. The accuracy has a tolerance of ± 0.05 mm to ± 0.15 mm for a true diameter ϕx. The assembly accuracy of two circuit boards needs to be set in consideration of the accuracy of the diameter of the through hole.

Further, Figure 2(C) illustrates a gap in design between a general through hole on a circuit board and a terminal to be inserted into the through hole. Generally, the gap is set to 0.1 mm to 0.5 mm. The larger the gap is, the lower the assembly accuracy of two circuit boards can be made. However, when the gap is too large, a fixing force between the circuit boards with solder may be insufficient or unstable.

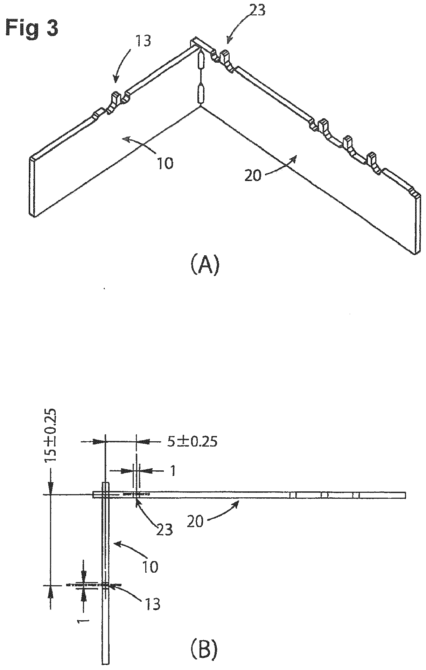

Figure 3 is a diagram illustrating a required accuracy of a relative position between terminals to be respectively smoothly inserted into through holes. As illustrated in JP 2020-025012A cited above and Figure 3(A), it is assumed that the first circuit board 10 and the second circuit board 20 are separately cut out and then assembled. The terminal corresponds to a protrusion of each of the circuit boards, and the protrusion is a part of the circuit board. Thus, the accuracy of the relative position between the terminals can be considered as the assembly accuracy of the two circuit boards.

In Figure 3, a positional relationship between the protrusion 13 in the first circuit board 10 and the protrusion 23 in the second circuit board 20 is defined in two directions. As illustrated in Figure 3(B), a distance between the center of the width of the protrusion 13 in the first circuit board 10 and the center of the thickness of the protrusion 23 in the second circuit board 20 is 15 mm, and a tolerance of the distance is ± 0.25 mm. That is, it is defined that the distance is to be within a range from 14.75 mm to 15.25 mm. In a direction perpendicular to a direction along the first circuit board 10, a distance between the center of the thickness of the protrusion 13 in the first circuit board 10 and the center of the width of the protrusion 23 in the second circuit board 23 is 5 mm, and a tolerance of the distance is ± 0.25 mm. That is, it is specified that the distance is to be within a range from 4.75 mm to 5.25 mm.

In the manufacturing method illustrated in Figure 1, the relative position between the first circuit board 10 and the second circuit board 20 is accurately maintained. Thus, the assembly accuracy can be substantially ignored. In other words, a bent plate-shaped metal fitting 50 rigid enough to maintain the assembly accuracy after the first circuit board 10 and the second circuit board 20 are cut out from the circuit board 1 of a large size has been provided.

Various types of embodiments of the circuit board assembly according to the invention will be described below. In the embodiments described below, the circuit board assemblies will be described by adopting reference numerals adopted in the circuit board assembly 100 illustrated in Figure 1 as they are for the sake of clarity even if different in form. Descriptions of features of the below described embodiments, which features correspond to those of first embodiment, have been omitted for the sake of brevity

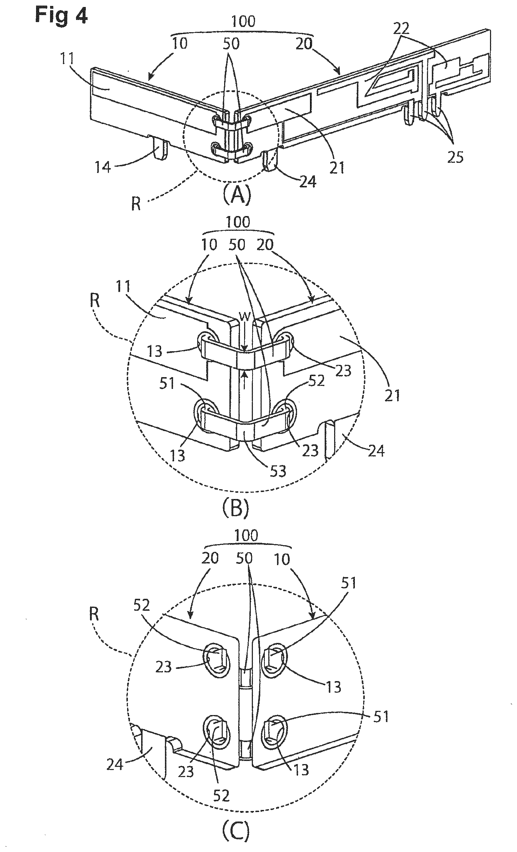

Figure 4 is a diagram illustrating a circuit board assembly according to a first embodiment of the invention. Figures 3(A), 3(B), and 3(C) are respectively an isometric view of a circuit board assembly 100, an enlarged view of a portion of a circle R indicated by a dotted line in Figure 3(A), and an enlarged view illustrating the rear side of the portion of the circle R.

The circuit board assembly 100 illustrated in Figure 4 is the same as the circuit board assembly 100 illustrated in Figure 1, and includes a first circuit board 10, a second circuit board 20, and a metal fitting 50 that connects the circuit boards.

A first circuit portion 11 is formed in the first circuit board 10, and a second circuit portion 21 and a third circuit portion 22 are formed in the second circuit board 10. The first circuit portion 11 and the second circuit portion 21 are electrically connected to each other by the metal fitting 50, to constitute one antenna.

Through holes 13 and 23 are respectively formed in the first circuit board 10 and the second circuit board 20, and end portions 51 and 52 of the metal fitting 50 are respectively inserted into the through holes 13 and 23. In the metal fitting 50, both the end portions 51 and 52 are respectively inserted into the through holes 13 and 23, and solder is poured into and attached to respective gaps between the through holes 13 and 23 and the end portions 51 and 52 of the metal fitting 50 inserted into the through holes 13 and 23. As a result, the metal fitting 50 mechanically connects the first circuit board 10 and the second circuit board 20 to each other. Out of illustrated two metal fittings 50, the metal fitting 50 illustrated on the upper side also electrically connects the first circuit portion 11 and the second circuit portion 21 to each other. A protrusion 14 is formed in the first circuit board 10, and protrusions 24 and 25 are formed in the second circuit board 20.

The metal fitting 50 is a flat metal plate punched in a strip shape and bent to insert both its end portions respectively into the through holes 13 and 23. In the metal fitting 50, both the end portions 51 and 52 are respectively inserted into and soldered to the through holes 13 and 23, and a central portion 53 is further bent at a predetermined angle (90° herein).

It is assumed that the first circuit board 10 and the second circuit board 20 are connected to each other by a jumper wire instead of the metal fitting 50. The jumper wire is for electrical connection, and a soft material having a relatively low rigidity is used for convenient handling. Accordingly, even if the first circuit board 10 and the second circuit board 20 are connected to each other by the jumper wire and the jumper wire is bent once such that a predetermined angle is formed between the first circuit board 10 and the second circuit board 20, a juxtaposition of the first circuit board 10 relative to the second circuit board 20 may change due to the action of gravity in the course of handling.

An example of the metal fitting 50 to be adopted is a metal fitting 50 made of a material and having dimensions and the like which is rigid enough to maintain a predetermined tolerance for an angle between the first circuit board 10 and the second circuit board 20 even if a posture in a direction of gravity of the circuit board assembly 100 is changed if bent once.

Therefore, when the metal fitting 50 is used, assembly working time for manufacturing a circuit board assembly 100 and the cost for producing it are reduced.

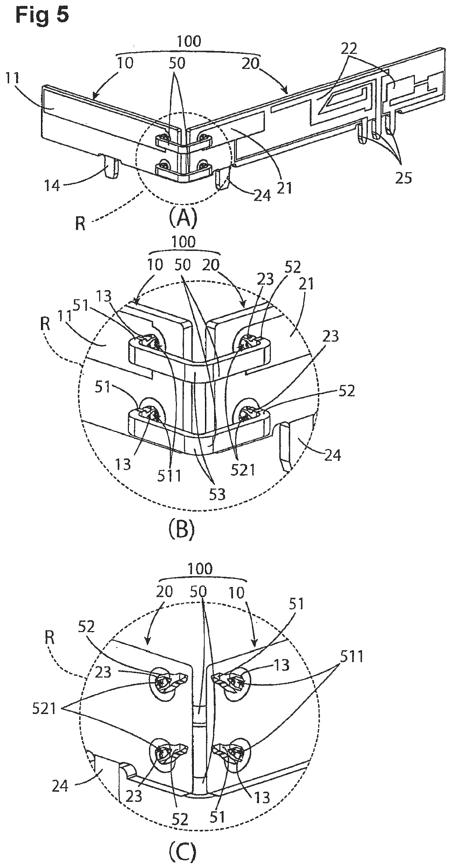

Figure 5 is a diagram illustrating a circuit board assembly according to a second embodiment of the invention. Figures 5(A), 5(B), and 5(C) are respectively an isometric view of a circuit board assembly 100, an enlarged view of a portion of a circle R indicated by a dotted line in Figure 5(A), and an enlarged view illustrating the rear side of the portion of the circle R.

A difference of the second embodiment illustrated in Figure 5 from the first embodiment illustrated in Figure 4 is a shape of both end portions 51 and 52 of a metal fitting 50. Both the end portions 51 and 52 of the metal fitting 50 are respectively provided with holes 511 and 521, and the end portions 51 and 52 are respectively inserted into through holes 13 and 23 to crush the holes 511 and 521. That is, the end portions 51 and 52 are respectively press-fitted into the through holes 13 and 23. Thus, the metal fitting 50 may connect the first circuit board 10 and the second circuit board 20 to each other by the press fitting. The metal fitting 50 is also obtained by punching a metal flat plate in a strip shape and bending both its end portions 51 and 52 and further bending its central portion 53, and corresponds to an example of a bent plate-shaped metal fitting referred to in the invention.

The first circuit board 10 and the second circuit board 20 may be more firmly connected to each other by both press fitting and soldering, although may be connected to each other by only press fitting of both the end portions 51 and 52 of the metal fitting 50.

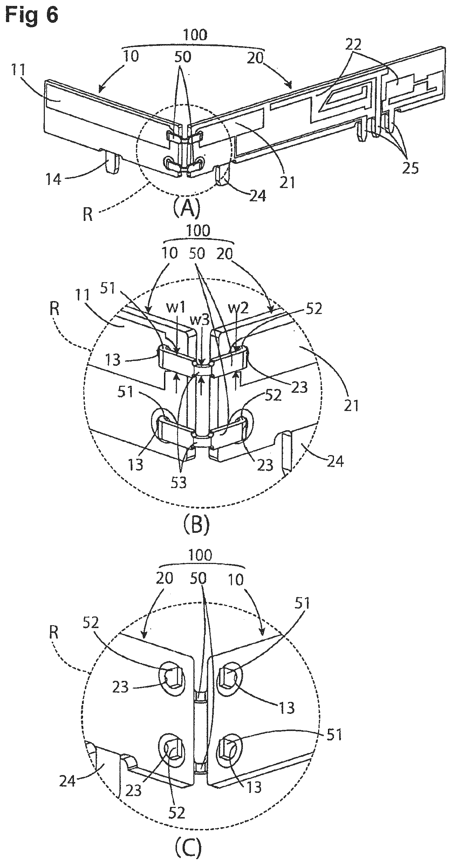

Figure 6 is a diagram illustrating a circuit board assembly according to a third embodiment of the invention. Figures 6(A), 6(B), and 6(C) are respectively an isometric view of a circuit board assembly 100, an enlarged view of a portion of a circle R indicated by a dotted line in Figure 6(A), and an enlarged view illustrating the rear side of the portion of the circle R.

Differences of the third embodiment illustrated in Figure 6 from the first embodiment illustrated in Figure 4 are relative dimensions of both end portions 51 and 52 of a metal fitting 50 and through holes 13 and 23 and the width of a central portion 53 of the metal fitting 50.

In the first embodiment illustrated in Figure 4, a width w of the metal fitting 50 is smaller than the diameter of the through holes 13 and 23, and both the end portions 51 and 52 are fixed to each other by soldering after being respectively inserted into the through holes 13 and 23. On the other hand, in the third embodiment illustrated in Figure 6, a width w of the metal fitting 50 is made slightly larger than the diameter of the through holes 13 and 23, and both the end portions 51 and 52 are respectively press-fitted into the through holes 13 and 23, although a cross-sectional shape of both the end portions 51 and 52 of the metal fitting 50 remains rectangular, like in the first embodiment. The end portions 51 and 52 may be more firmly fixed to each other using press fitting and soldering in combination. In the metal fitting 50 in the third embodiment illustrated in Figure 6, a width w3 of the central portion 53 is smaller than a width w1/w2 of both the end portions 51 and 52. This is because a position where the metal fitting 50 is bent is guided to the central portion 53 to make it easy to bend the central portion 53 at a correct angle when an angle is formed between the first circuit board 10 and the second circuit board 20.

The metal fitting 50 illustrated in Figure 6 is also obtained by punching a flat metal plate in a strip shape and bending both of its end portions 51 and 52 and further bending its central portion 53, and corresponds to an example of a bent plate-shaped metal fitting referred to in the invention.

Both the end portions 51 and 52 of the metal fitting 50 may be respectively inserted into and soldered to the through holes 13 and 23, or may be respectively press-fitted into the through holes 13 and 23, or soldering and press fitting may be used in combination, as illustrated in the examples described above. These alternative methodsfor fixing the end portions 51 and 52 respectively into the through holes 13 and 23 applies to the embodiments described below but, for the sake of brevity, are not referred to in the descriptions of these embodiments

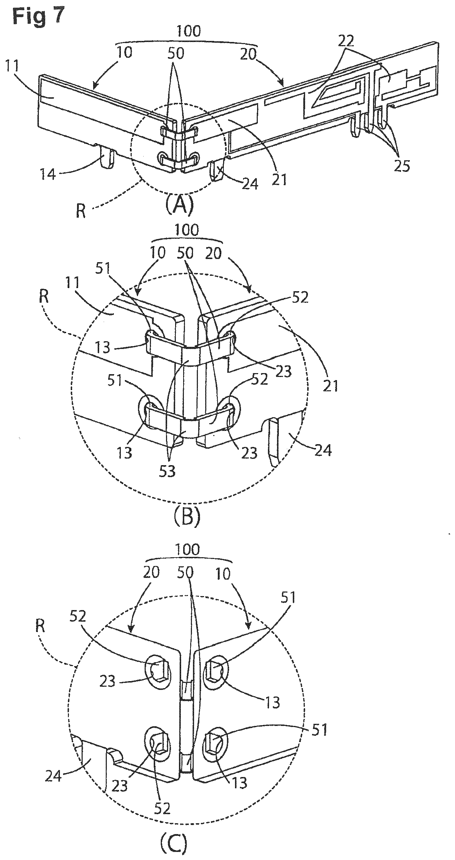

Figure 7 is a diagram illustrating a circuit board assembly according to a fourth embodiment of the invention. Figures 7(A), 7(B), and 7(C) are respectively an isometric view of a circuit board assembly 100, an enlarged view of a portion of a circle R indicated by a dotted line in Figure 7(A), and an enlarged view illustrating the rear side of the portion of the circle R.

In a metal fitting 50 in the third embodiment illustrated in Figure 7, the wall thickness of a central portion 53 is smaller than that of both end portions 51 and 52. This is also for making it easy to bend the central portion 53, as in the third embodiment illustrated in Figure 6.

The metal fitting 50 illustrated in Figure 7 is also obtained by punching a flat metal plate in a strip shape, crushing its central portion 53 such that the wall thickness thereof decreases at the time of the punching, bending both its end portions 51 and 52 and further bending the central portion 53, and corresponds to an example of a bent plate-shaped metal fitting referred to in the invention.

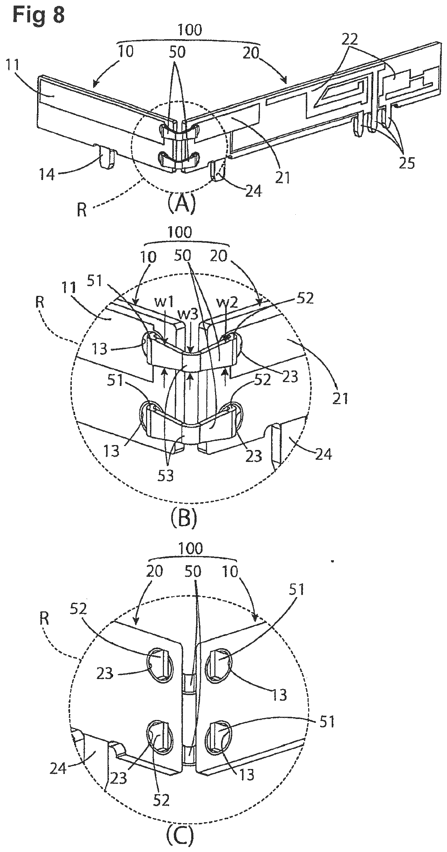

Figure 8 is a diagram illustrating a circuit board assembly according to a fifth embodiment of the invention. Figures 8(A), 8(B), and 8(C) are respectively an isometric view of a circuit board assembly 100, an enlarged view of a portion of a circle R indicated by a dotted line in Figure 8(A), and an enlarged view illustrating the rear side of the portion of the circle R.

In metal fitting 50 in the fifth embodiment illustrated in Figure 8, a width w3 of a central portion 53 is smaller than a width w1/w2 of both end portions 51 and 52. The metal fitting 50 increases in width toward both the end portions 51 and 52. This is for making it easy to bend the central portion 53, as in the third embodiment and the forth embodiment illustrated in Figure 6 and Figure 7.

The metal fitting 50 illustrated in Figure 8 is also obtained by punching a flat metal plate in a strip shape, bending both of its end portions 51 and 52 and further bending its central portion 53, and corresponds to an example of a bent plate-shaped metal fitting referred to in the invention.

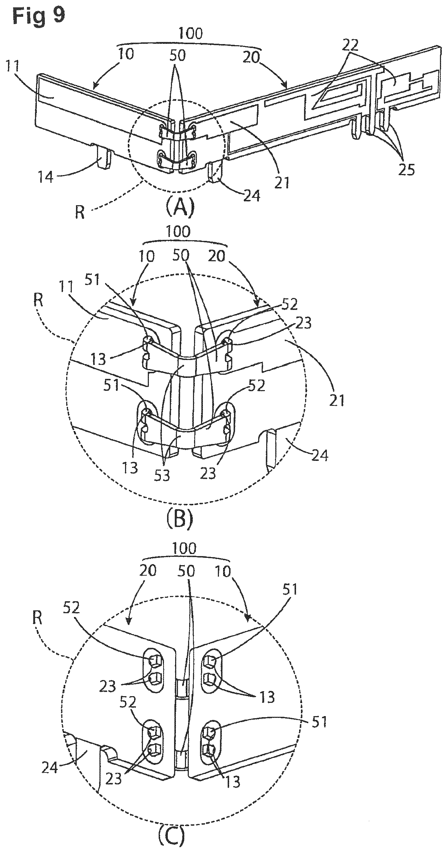

Figure 9 is a diagram illustrating a circuit board assembly according to a sixth embodiment of the invention. Figures 9(A), 9(B), and 9(C) are respectively an isometric view of a circuit board assembly 100, an enlarged view of a portion of a circle R indicated by a dotted line in Figure 9(A), and an enlarged view illustrating the rear side of the portion of the circle R.

In a metal fitting 50 in the sixth embodiment illustrated in Figure 9, each of both end portions 51 and 52 is two-pronged. Correspondingly, two through holes 13 in a first circuit board 10 and two through holes 23 in a second circuit board 20 are also formed for each metal fitting 50. Both the two-pronged end portions 51 and the two-pronged end portions 52 are respectively inserted into the two through holes 13 and the two through holes 23. When both the end portions 51 and 52 are thus each two-pronged, the number of contact points between the first circuit board 10 and the second circuit board 20 and the metal fitting 50 increases so that the first circuit board 10 and the second circuit board 20 are mechanically firmly fixed to each other and more reliably electrically connected to each other.

The metal fitting 50 illustrated in Figure 9 is also obtained by punching a flat metal plate, bending both of its end portions 51 and 52 and further bending its central portion 53, and corresponds to an example of a bent plate-shaped metal fitting referred to in the invention.

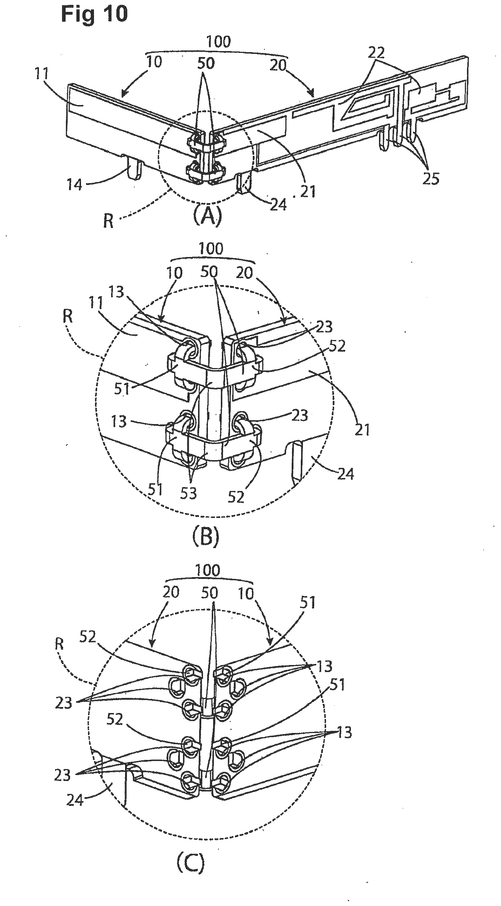

Figure 10 is a diagram illustrating a circuit board assembly according to a seventh embodiment of the invention. Figures 10(A), 10(B), and 10(C) are respectively an isometric view of a circuit board assembly 100, an enlarged view of a portion of a circle R indicated by a dotted line in Figure 10(A), and an enlarged view illustrating the rear side of the portion of the circle R.

In a metal fitting 50 in the seventh embodiment illustrated in Figure 10, each of both end portions 51 and 52 is three-pronged. Correspondingly, three through holes 13 in a first circuit board 10 and three through holes 23 in a second circuit board 20 are also formed for each metal fitting 50. Both the three-pronged end portions 51 and the three-pronged end portions 52 are respectively inserted into the three through holes 13 and the three through holes 23. The reason why each of both the end portions 51 and 52 is three-pronged is the same as the reason why each of both the end portions 51 is two-pronged. That is, when both the end portions 51 and 52 are each three-pronged, the number of contact points between the first circuit board 10 and the second circuit board 20 and the metal fitting 50 increases so that the first circuit board 10 and the second circuit board 20 are mechanically firmly fixed to each other and more reliably electrically connected to each other.

The metal fitting 50 illustrated in Figure 10 is also obtained by punching a flat metal plate, bending both of its end portions 51 and 52 and further bending its central portion 53, and corresponds to an example of a bent plate-shaped metal fitting referred to in the invention.

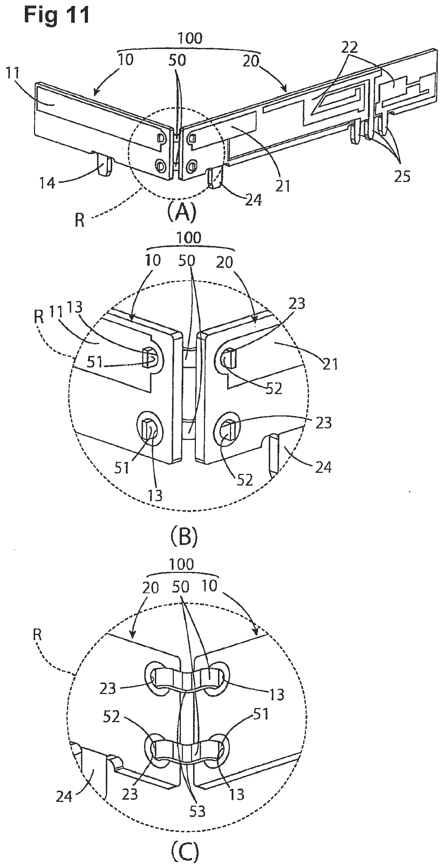

Figure 11 is a diagram illustrating a circuit board assembly according to an eighth embodiment of the invention. Figures 11(A), 11(B), and 11(C) are respectively an isometric view of a circuit board assembly 100, an enlarged view of a portion of a circle R indicated by a dotted line in Figure 11(A), and an enlarged view illustrating the rear side of the portion of the circle R.

In the first to seventh embodiments illustrated in Figures 4 to 10, the metal fitting 50 couples the first circuit board 10 and the second circuit board 20 to each other via the side at an obtuse angle (the side opened at an angle of 270°). On the other hand, the circuit board assembly 100 in the eighth embodiment illustrated in Figure 11 couples a first circuit board 10 and a second circuit board 20 to each other via the side at an acute angle (the side opened at an angle of 90°).

A metal fitting 50 illustrated in Figure 11 is also obtained by punching a flat metal plate, bending both of its end portions 51 and 52 and further bending its central portion 53, and corresponds to an example of a bent plate-shaped metal fitting referred to in the invention.

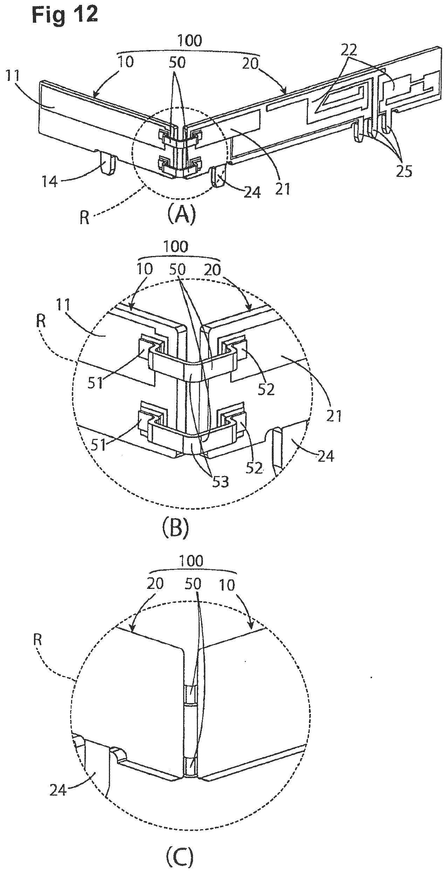

Figure 12 is a diagram illustrating a circuit board assembly according to a ninth embodiment of the invention. Figures 12(A), 12(B), and 12(C) are respectively an isometric view of a circuit board assembly 100, an enlarged view of a portion of a circle R indicated by a dotted line in Figure 12(A), and an enlarged view illustrating the rear side of the portion of the circle R.

In the first to ninth embodiments illustrated in Figures 4 to 11, the through holes 13 and 23 are respectively formed in the first circuit board 10 and the second circuit board 20, and the metal fitting 50 couples the first circuit board 10 and the second circuit board 20 to each other with both the end portions 51 and 52 respectively inserted into the through holes 13 and 23. On the other hand, in the circuit board assembly 100 according to the ninth embodiment illustrated in Figure 12 the end portions 51 and 52 are bent in a direction in which they extend in a direction along respective surfaces of a first circuit board 10 and a second circuit board 20, and are respectively soldered to the surfaces of the first circuit board 10 and the second circuit board 20.

Thus, the metal fitting 50 may be soldered to the respective surfaces of the first circuit board 10 and the second circuit board 20.

The metal fitting 50 illustrated in Figure 12 is also obtained by punching a flat metal plate, bending both of its end portions 51 and 52 and further bending its central portion 53, and corresponds to an example of a bent plate-shaped metal fitting referred to in the invention.

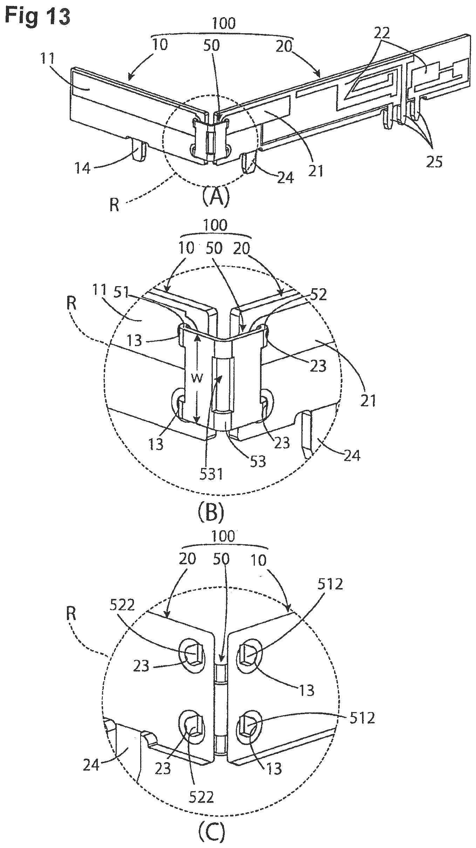

Figure 13 is a diagram illustrating a circuit board assembly according to a tenth embodiment of the invention. Figures 13(A), 13(B), and 13(C) are respectively an isometric view of a circuit board assembly 100, an enlarged view of a portion of a circle R indicated by a dotted line in Figure 13(A), and an enlarged view illustrating the rear side of the portion of the circle R.

In the first to ninth embodiments illustrated in Figures 4 to 12, the first circuit board 10 and the second circuit board 20 are coupled to each other by the two metal fittings 50. On the other hand, in the tenth embodiment illustrated in Figure 13, a first circuit board 10 and a second circuit board 20 are connected to each other by one metal fitting 50 having a large width w. Although the number of metal fittings 50 is one, two through holes 13 and two through holes 23 are respectively formed in the first circuit board 10 and the second circuit board 20. Accordingly, two leg portions 512 and two leg portions 522 are respectively formed in both end portions 51 and 52 of the metal fitting 50, and the one leg portion 512 and the one leg portion 522 are respectively inserted into each of the through holes 13 and each of the through holes 23.

A hole 531 is formed in a central portion 53 of the metal fitting 50 such that the central portion 53 can be bent with an appropriate force.

Thus, the number of metal fittings 50 that each couple the first circuit board 10 and the second circuit board 20 to each other need not be two, may be one, as illustrated in Figure 13, or may be three or more, although illustration thereof is omitted.

The metal fitting 50 illustrated in Figure 13 is also obtained by punching a flat metal plate, bending both of its end portions 51 and 52 and further bending its central portion 53, and corresponds to an example of a bent plate-shaped metal fitting referred to in the invention.

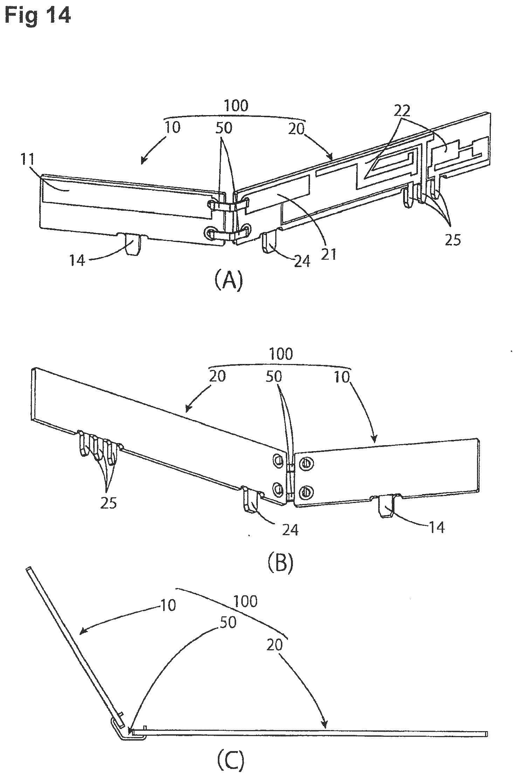

Figure 14 is a diagram illustrating a circuit board assembly according to an eleventh embodiment of the invention. Figures 14(A), 14(B), and 14(C) are respectively an isometric view of a circuit board assembly 100 as viewed from the front surface side thereof and an isometric view and a side view of the circuit board assembly 100 as viewed from the rear surface side thereof.

In the first to tenth embodiments illustrated in Figures 4 to 13, the metal fitting 50 couples the first circuit board 10 and the second circuit board 20 to each other to maintain a posture in which the first circuit board 10 and the second circuit board 20 are disposed at an angle of 90° to each other. On the other hand, the circuit board assembly 100 according to the eleventh embodiment illustrated in Figure 14 couples a first circuit board 10 and a second circuit board 20 to each other to maintain a posture in which the first circuit board 10 and the second circuit board 20 are opened at an angle of not 90° but 120°, for example.

An angle formed between the first circuit board 10 and the second circuit board 20 need not be 90° but may be any angle excluding 180°, as illustrated in Figure 14.

A metal fitting 50 illustrated in Figure 14 is also obtained by punching a flat metal plate, bending both of its end portions 51 and 52 and further bending its central portion 53, and corresponds to an example of a bent plate-shaped metal fitting referred to in the invention.

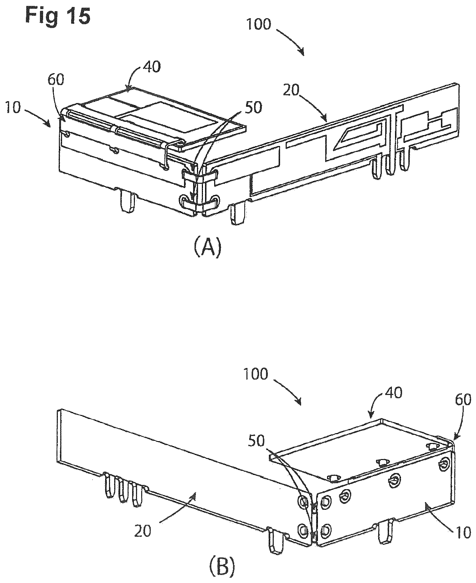

Figure 15 is a diagram illustrating a circuit board assembly according to a twelfth embodiment of the invention. Figures 15(A) and 15(B) are respectively isometric views of a circuit board assembly 100 as viewed from the front surface side and the rear surface side thereof.

In the first to eleventh embodiments illustrated in Figures 4 to 14, the circuit board assembly 100 has a structure in which the two circuit boards, i.e., the first circuit board 10 and the second circuit board 20 are connected to each other by the metal fitting 50. However, the circuit board assembly 100 illustrated in Figure 15 further includes a fourth circuit board 40 and a metal fitting 60. The fourth circuit board 40 is connected to a first circuit board 10 by the metal fitting 60.

Thus, the circuit board assembly according to the invention may have a structure obtained by connecting three or more circuit boards to one another.

The metal fitting 60 is also obtained by punching a flat metal plate, bending both of its end portions and further bending its central portion, and corresponds to an example of a bent plate-shaped metal fitting referred to in the invention.

As described above, according to the invention, an angle between circuit boards and a positional relationship between the circuit boards are precisely adjusted, and a circuit board assembly that has attained low cost is implemented, as illustrated in the first to twelfth embodiments.

### Reference Signs List

1...Circuit board of large size
1A...Frame of circuit board of large size
10...First circuit board
101...First side
102...Second side
11...First circuit portion
13...Through hole
14...Protrusion
20...Second circuit board
201...First side
202...Second side
21...Second circuit portion
22...Third circuit portion
23...Through hole
24...Protrusion
25...Protrusion
30...Third circuit board
31, 32, 33...Through hole
40...Fourth circuit board
50...Metal fitting
51, 52...End portion
511, 521...Hole
512, 522...Leg portion
53...Central portion
531...Hole
60...Metal fitting
100...Circuit board assembly

## Claims

1. A circuit board assembly (100) comprising:
a first circuit board (10); and
a second circuit board (20) having a first side (201) extending adjacent to and parallel to a first side (101) of the first circuit board (10) and being in a position having an angle excluding 180° to the first circuit board (10); and
a metal fitting (50) including a portion (53) bent at an angle corresponding to the angle, spanning both the respective first sides (101, 201) of the first circuit board (10) and the second circuit board (20), and fixed to both the first circuit board (10) and the second circuit board (20),
wherein the metal fitting (50) has a rigidity with which a bent configuration is maintained regardless of respective positions of the first circuit board (10) and the second circuit board (20) with respect to gravity.

2. A circuit board assembly (100) comprising:
a first circuit board (10); and
a second circuit board (20) having a first side (201) extending adjacent to and parallel to a first side (101) of the first circuit board (10) and being in a position having an angle excluding 180° to the first circuit board (10); and
a bent plate-shaped metal fitting (50) including a portion (53) bent at an angle corresponding to the angle, spanning the respective first sides (101, 201) of both the first circuit board (10) and the second circuit board (20), and fixed to both the first circuit board (10) and the second circuit board (20).

3. The circuit board assembly (100) according to claim 1 or 2, wherein
both the first circuit board (10) and the second circuit board (20) include respective second sides (102, 202) to be mounted on a support portion (30), the second sides (102, 202)including protrusions (14, 24, 25) protruding from the second sides (102, 202) to be inserted into insertion portions (31, 32, 33) formed in the support portion (30), and
the metal fitting (50) is rigid enough to maintain an angle between the first circuit board (10) and the second circuit board (20) before being inserted into the support portion (30), at which angle the protrusions (14, 24, 25) can be respectively inserted into the insertion portions (31, 32, 33) .

4. The circuit board assembly (100) according to claim 3, wherein the first circuit board (10), the second circuit board (20), and the support portion (30) form one circuit.

5. The circuit board assembly according to any of claims 1 to 4, wherein
the first circuit board (10) and the second circuit board (20) respectively include a first circuit portion (11) and a second circuit portion (21) that are electrically connected to each other to perform a function, and
the metal fitting (50) provides mechanical fixing of the first circuit board (10) and the second circuit board (20) and electrical connection between the first circuit portion (11) and the second circuit portion (21).

6. The circuit board assembly (100) according to claim 5, wherein both the first circuit portion (11) and the second circuit portion (21) are respectively circuit portions constituting an antenna.

7. The circuit board assembly (100) according to any of claims 1 to 6, wherein
the first circuit board (10) and the second circuit board (20) respectively include receiving portions (13, 23) that receive the metal fitting (50), and
the metal fitting (50) is press-fitted into each of the receiving portions (13, 23).

8. The circuit board assembly (100) according to any of claims 1 to 7, wherein the metal fitting (50) is soldered to both the first circuit board (10) and the second circuit board (20).
